# EUROPÄISCHE PATENTSCHRIFT

(11) **EP 2 516 321 B1**
(45) Veröffentlichungstag und Bekanntmachung des Hinweises auf die Patenterteilung: **06.03.2019**
(21) Anmeldenummer: 11817213.9
(22) Anmeldetag: 10.10.2011
(51) Int. Cl.: B81B 7/00

(54) **SENSOR MIT EINEM VORZUGSWEISE MEHRSCHICHTIGEN KERAMIKSUBSTRAT UND VERFAHREN ZU DESSEN HERSTELLUNG**
SENSOR COMPRISING A PREFERABLY MULTILAYERED CERAMIC SUBSTRATE AND METHOD FOR PRODUCING IT
CAPTEUR COMPORTANT UN SUBSTRAT CÉRAMIQUE DE PRÉFÉRENCE MULTICOUCHE ET PROCÉDÉ DE FABRICATION CORRESPONDANT

(30) Priorität: 02.12.2010 DE 102010053021; 08.12.2010 DE 102010053760
(43) Veröffentlichungstag der Anmeldung: 31.10.2012
(73) Patentinhaber: Micro-Epsilon Messtechnik GmbH & Co. KG, 94496 Ortenburg (DE)
(72) Erfinder: SCHMIDEDER, Sabine, 84329 Wurmannsquick (DE); THELEMANN, Torsten, 99310 Arnstadt (DE); NAGL, Josef, 94550 Künzing (DE); ASCHENBRENNER, Heinrich, 94496 Ortenburg (DE); HOENICKA, Reinhold, 94496 Ortenburg (DE)
(74) Vertreter: Patent- und Rechtsanwälte Ullrich & Naumann
(86) Internationale Anmeldenummer: PCT/DE2011/050042
(87) Internationale Veröffentlichungsnummer: WO 2012/072070

(56) Entgegenhaltungen:
- EP-A2- 1 443 331
- DE-A1- 10 314 875
- DE-B4-102004 024 920
- JP-A- H03 147 357
- JP-A- S60 187 046
- US-A- 3 941 916
- US-A- 5 036 431
- US-A- 5 368 220

## Beschreibung

Die Erfindung betrifft ganz allgemein einen Sensor, der ein mehrschichtiges Keramiksubstrat umfasst, wobei in dem Keramiksubstrat mindestens ein Sensorelement angeordnet bzw. ausgebildet ist. Des Weiteren betrifft die Erfindung ein Verfahren zur Herstellung eines solchen Sensors.

Während Elektronikbaugruppen bislang auf herkömmlichen Leiterplatten gefertigt wurden, werden diese heutzutage zunehmend auf bzw. in Keramiksubstraten erzeugt. Die Verwendung von Keramik hat gleich mehrere Vorteile. Von besonderer Bedeutung ist die hohe Temperaturbeständigkeit der Keramik. Außerdem ist die Ausdehnung der Keramik gegenüber herkömmlichen Leiterplatten im Temperaturverlauf deutlich geringer. Es ist außerdem möglich, mehrlagige Keramiken mit integrierten Leiterbahnstrukturen in bzw. zwischen den Schichten herzustellen. Zwischen den Schichten lassen sich sogar elektrische/elektronische Bauelemente realisieren. Dies führt zu einer äußerst kompakten Bauform. Die Kontaktierung solcher Elektronikbaugruppen erfolgt üblicherweise mittels sogenannter Lötpads, die auf dem Substrat aufgedruckt werden. Auf die Lötpads wird im herkömmlichen Weichlötverfahren der Kontakt in Form einer Litze, einer Metallfahne oder ähnlichem gelötet. Das Weichlöten hat den Nachteil, dass das verwendete Lötzinn bereits bei Temperaturen von 200°C bis 300°C schmilzt. Dies eliminiert den enormen Vorteil einer hohen Temperaturbeständigkeit der Keramik, die nämlich bei Verwendung von herkömmlichem Lötzinn beim Weichlöten nicht genutzt werden kann.

Herkömmliche Lötungen sind auch insoweit nachteilig, als die Verbindung mit dem Lötpad eine ausschließlich elektrische Verbindung ist. In mechanischer Hinsicht ist eine solche Verbindung äußerst instabil. Entsprechend darf die Lötstelle kaum mechanisch belastet werden. Bei Schock, Vibration oder sonstiger mechanischer Belastung brechen oder reißen solche Lötstellen häufig. Folglich ist eine separate mechanische Fixierung, beispielsweise durch Kleben, Fügen, etc. erforderlich.

Eine Alternative zum herkömmlichen Weichlöten ist das Hartlötverfahren, bei dem die Löttemperatur oberhalb von 450°C liegt. Eine besondere Form des Hartlötens ist das Aktivlöten. Handelsübliche Aktivlote haben einen Schmelzpunkt von ca. 850°C. Außerdem ist es von Vorteil, dass mittels Aktivlöten Metall direkt auf der Keramik verlötet werden kann. Eine beim herkömmlichen Weichlöten oder Hartlöten übliche Metallisierung der Keramik ist beim Aktivlöten nicht erforderlich, da das Lot aufgrund seiner chemischen Zusammensetzung eine direkte Verbindung mit der Keramikoberfläche eingeht. Durch den Zusatz spezifischer Legierungselemente wie beispielsweise Titan entsteht beim Aktivlöten eine Reaktion an der Grenzfläche, nämlich zwischen dem Metall bzw. der Metalllegierung des Lots und der Keramikoberfläche, so dass sich die Materialien direkt miteinander verbinden, ohne Zwischenschaltung eines Haftvermittlers. Der besondere Vorteil des Aktivlötens besteht daher in der hohen mechanischen Festigkeit und hohen Temperaturbeständigkeit der Verbindung. Folglich lässt sich durch Aktivlöten eine hochtemperaturtaugliche Metall-Keramik-Verbindung herstellen.

Sensoren der gattungsbildenden Art sind aus der Praxis bekannt. Solche Sensoren gibt es auch bereits aus mehrschichtiger Keramik. Lediglich beispielhaft sei dazu verwiesen auf die DE 10 2008 016 829 A1 und DE 103 14 875 A1. Des Weiteren zeigen die Dokumente JP 03147357 A und US 5036431 A verschiedene Ausgestaltungen von Sensoren sowie Verfahren zur Herstellung solcher Sensoren.

JP 60187046 A offenbart ein Bauteil auf einem gesinterten mehrschichtigen Keramiksubstrat mit Pins als elektrischen Kontakts. Diese Bauteil ist jedoch kein Sensor und ist auf und nicht in dem Substrat.

US 2002/0007677 A1 (insbesondere Figur 4) bezieht sich auf ein Sensor in einem mehrschichtigen Keramiksubstrat offenbart jedoch nicht (i) dass die Keramik Schichten durch Sintern verbunden sind ; und (ii) dass der metallische Kontakt in Form eines eingesteckten Pins oder Stifts ist und durch ein Lotverbindung eingebracht ist.

Auch bei den hier in Rede stehenden Sensoren stellt die Verbindung zwischen Metall und Keramik ein besonderes Problem dar. Da das eigentliche Sensorelement meist an, auf oder in der Keramik bzw. dem Keramiksubstrat angeordnet ist und beispielsweise mindestens eine Messelektrode oder mindestens eine Messspule elektrisch kontaktiert werden muss, besteht das grundsätzliche Problem, wie man eine solche elektrische Verbindung unter gleichzeitiger Erzeugung einer hinreichend guten mechanischen Verbindung fehlerfrei und nachhaltig erzeugen kann.

Üblicherweise werden auch bei Sensoren metallische Kontakte auf die Keramik aufgebracht, beispielsweise durch Löten. Solche Metall-Keramik-Lötverbindungen sind - für sich gesehen - ebenfalls bereits bekannt. Dazu sei auf die DE 10 2004 024 920 B4 verwiesen. Im Konkreten ist aus der DE 10 2004 024 920 B4 ein Drucksensor bekannt, bei dem ein Keramiksubstrat mittels Aktiv- oder Hartlöten mit einer fest mit dem Anschlussgehäuse des Drucksensors verbundenen Tragstruktur aus Metall verbunden ist. Dort ist nachteilig, dass das Keramiksubstrat selbst nur als Haltevorrichtung für die eigentliche Druckmesszelle dient. Diese Druckmesszelle ist wiederum aus Metall und mit dem Keramiksubstrat durch Aktivlöten auf einer Seite verbunden. Auf der anderen Seite des Keramiksubstrats sind Anschlussstifte vorgesehen.

Die bei Sensoren bekannten Maßnahmen zur elektrischen Kontaktierung sind jedoch in der Praxis insoweit problematisch, als sie einerseits einen erheblichen Aufwand in der Handhabung/Herstellung hervorrufen und andererseits nur bedingt äußeren - mechanischen - Einwirkungen Stand halten. Solche durch Löten erzeugte Kontaktierungen sind äußerst "sensibel" und daher störanfällig.

Der vorliegenden Erfindung liegt daher die Aufgabe zugrunde, einen Sensor anzugeben, bei dem das Sensorelement in einem mehrschichtigen Keramiksubstrat angeordnet bzw. entsprechend erzeugt ist und bei dem eine sichere Kontaktierung des Sensorelements bei einfachster Technologie realisiert ist. Außerdem soll der Sensor einfach aufgebaut und daher kostengünstig herstellbar sein.

Die voranstehende Aufgabe ist in Bezug auf einen erfindungsgemäßen Sensor durch die Merkmale des Patentanspruchs 1 gelöst. Damit ist ein Sensor mit einem mehrschichtigen Keramiksubstrat und mindestens einem in dem Keramiksubstrat angeordneten Sensorelement beansprucht, welches über einen metallischen Kontakt kontaktierbar ist, wobei die einzelnen Schichten des Keramiksubstrates durch Sintern fest miteinander verbunden sind, wobei der metallische Kontakt über eine Lötverbindung hergestellt ist, die den Kontakt elektrisch mit dem Sensorelement verbindet und dabei eine feste mechanische Verbindung des Kontakts gegenüber dem Keramiksubstrat erzeugt, wobei der metallische Kontakt in Form eines in das Keramiksubstrat eingesteckten Pins oder Stifts ausgeführt ist, wobei das Sensorelement zur induktiven oder kapazitiven Weg-/Abstands-/Positionsmessung dient, wobei die Kontaktierung gegenüber einer oder mehreren Spulen und/oder gegenüber einer oder mehrerer Elektrodenflächen ausgebildet ist und wobei der metallische Kontakt in einem Sackloch des Keramiksubstrats eingesteckt ist.

In Bezug auf ein erfindungsgemäßes Verfahren ist die vorliegende Erfindung durch die Merkmale des nebengeordneten Patentanspruchs 6 gelöst, der sich auf die Herstellung des erfindungsgemäßen Sensors bezieht, wobei mindestens ein Sensorelement, welches zur induktiven oder kapazitiven Weg-/Abstands-/Positionsmessung dient, in einem Keramiksubstrat erzeugt wird, wobei das Keramiksubstrat ein mehrschichtiges Keramiksubstrat ist, wobei die einzelnen Schichten des Keramiksubstrats durch Sintern fest miteinander verbunden werden, wobei sowohl zur elektrischen Kontaktierung als auch zur mechanischen Verbindung eines metallischen Kontakts dieser durch Aktivlöten in ein Sackloch des Keramiksubstrats eingebracht und mit dem Keramiksubstrat fest verbunden wird.

Im Falle eines induktiven Abstands- oder Positionssensors umfasst das Sensorelement eine oder mehrere Spulen. Zur kapazitiven Abstandsmessung sind eine oder mehrere Elektrodenflächen vorgesehen.

Besonders vorteilhaft ist die Verwendung von Aktivlöten in der Sensorik. Sensoren müssen häufig in besonders widrigen Umgebungsbedingungen eingesetzt werden, beispielsweise bei hoher Temperatur oder unter Schockbelastung und Vibrationen. Eine Schwachstelle der Sensoren ist deren Anschluss, d. h. das Kabel. Die Verbindung zwischen der Metalllitze des Kabels mit der Elektronikbaugruppe des Sensors kann bei Schockbelastung oder Vibrationen leicht beschädigt werden. Hier ist der Einsatz von Aktivlöten besonders geeignet, um gleichzeitig Sensoren mit hoher Temperaturbeständigkeit und großer Resistenz gegen mechanische Belastungen herzustellen.

In erfindungsgemäßer Weise ist die Verwendung von mehrlagigen Keramiksubstraten vorgesehen, die durch Sintern fest miteinander verbunden sind. In den einzelnen Lagen des Substrates können die Sensorelemente aufgebracht sein, beispielsweise die Spule eines Abstandssensors durch Aufdrucken einer Leiterbahnschicht. Nach dem Aufeinanderstapeln der einzelnen Schichten und dem Sintern entsteht ein massiver Keramikblock, der in seinem Inneren die Sensorelemente enthält. Diese sind dadurch vor Umgebungseinflüssen geschützt und mechanisch stabil.

Die Kontaktierung des Sensorelements auf dem Keramiksubstrat wird derart hergestellt, dass durch Aktivlöten eines geeigneten Metall-Anschlussstücks auf das Keramiksubstrat eine gleichzeitig elektrisch leitende und mechanisch stabile Verbindung entsteht. Dies geschieht dadurch, dass die Auflagefläche des Kontaktes auf dem Keramiksubstrat gleichzeitig einerseits die elektrische Kontaktfläche, beispielsweise die Leiterbahn oder das Lötpad, bedeckt und andererseits die unbedeckte Keramikoberfläche überdeckt. Beim Lötprozess wird dann durch das Aktivlot gleichzeitig sowohl die elektrische Verbindung zwischen der Kontaktfläche und dem metallischen Kontakt als auch die mechanische Verbindung mit der Keramikoberfläche und dem Kontakt hergestellt.

Der metallische Kontakt kann in weiter vorteilhafter Weise durch Aktivlöten unmittelbar in dem Keramiksubstrat mit diesem verbunden sein. Der metallische Kontakt ist in Form eines in das Keramiksubstrat eingesteckten Stifts/Pins ausgeführt, so dass bereits durch das Einstecken des Kontakts eine gewisse Positionsstabilität, möglicherweise auch durch Realisierung einer gewissen Passung, erreicht wird.

Der metallische Kontakt kann in vorteilhafter Weise derart dimensioniert, dass er mit zumindest geringem Spiel, d.h. ohne Realisierung einer Presspassung, in das Keramiksubstrat eingesteckt wird. Der sich ergebende Spalt zwischen dem Kontakt und dem Keramiksubstrat kann dabei derart ausgelegt sein, dass das Aktivlot bzw. die Lotpaste sich gleichmäßig und ausreichend in dem Spalt verteilt, wobei eine exakte Dosierung der Lötpaste in dem Spalt, möglichst vor dem Einstecken des metallischen Kontakts, von Vorteil ist.

In weiter vorteilhafter Weise ist die durch den metallischen Kontakt zu kontaktierende Messelektrode oder Messspule im Innern oder auf der der Einsteckseite gegenüberliegenden Seite des Keramiksubstrats vorgesehen. Zwischen der Messelektrode bzw. Messspule und dem metallischen Kontakt ist in weiter vorteilhafter Weise ein den elektrischen Kontakt begünstigendes Material, vorzugsweise eine Kontakt-Paste, vorgesehen. Diese wird vorzugsweise vor der Sinterung des Keramiksubstrats auf die zu kontaktierende Messelektrode oder Messspule aufgebracht, so dass beim anschließenden Aktivlöten, bei einer Temperatur von etwa 850°C, eine hervorragende elektrische wie auch mechanische Verbindung gegenüber dem metallischen Kontakt herstellbar ist.

Im Lichte der voranstehenden Ausführungen ist nicht nur eine einwandfreie elektrische Kontaktierung zwischen dem metallischen Kontakt und einer Kontaktfläche des Sensorelements, beispielsweise einer Messelektrode oder Messspule des Sensorelements, realisiert, sondern vielmehr auch eine einwandfreie mechanische Verankerung bzw. Befestigung des metallischen Kontakts in bzw. an dem Keramiksubstrat.

Das erfindungsgemäße Verfahren dient zur Herstellung des zuvor erörterten Sensors und basiert im Wesentlichen darauf, dass das Keramiksubstrat sintertechnologisch hergestellt wird und der zur elektrischen Kontaktierung dienende metallische Kontakt nach dem Sintern des Keramiksubstrats in dieses eingebracht und dort sowohl zur elektrischen Kontaktierung wie auch zur mechanischen Verankerung mittels Aktivlot verlötet wird. Ein den elektrischen Kontakt begünstigendes Material, beispielsweise in Form einer Kontakt-Paste, kann bereits vor der Sinterung des Keramiksubstrats in dieses eingebracht werden.

Es gibt nun verschiedene Möglichkeiten, die Lehre der vorliegenden Erfindung in vorteilhafter Weise auszugestalten und weiterzubilden. Dazu ist einerseits auf die dem Patentanspruch 1 und dem Patentanspruch 6 nachgeordneten Patentansprüche und andererseits auf die nachfolgende Erläuterung bevorzugter Ausführungsbeispiele der Erfindung anhand der Zeichnung zu verweisen. In Verbindung mit der Erläuterung der bevorzugten Ausführungsbeispiele der Erfindung anhand der Zeichnung werden auch im Allgemeinen bevorzugte Ausgestaltungen und Weiterbildungen der Lehre erläutert. In der Zeichnung zeigen
- Fig. 1: in einer schematischen Ansicht, teilweise geschnitten, den grundsätzlichen Aufbau eines Sensors,
- Fig. 2: in einer schematischen Ansicht, geschnitten und ausschnittsweise ein Ausführungsbeispiel eines erfindungsgemäßen Sensors im Bereich der Kontaktierung und
- Fig. 3: in einer schematischen Ansicht, geschnitten und ausschnittsweise einen erfindungsgemäßen Sensor im Bereich der Kontaktierung.

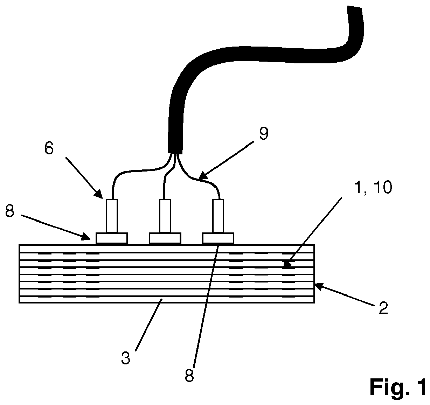

Fig. 1 zeigt ein Ausführungsbeispiel eines Sensors, bei dem das Metall-Anschlussstück als Pin 6 mit einer zur Befestigung dienenden Auflagefläche ausgeführt ist. Die Auflagefläche bildet die Kontaktstelle zum Keramiksubstrat 2, indem diese mittels eines Aktivlotes 8 miteinander verbunden werden. Die Auflagefläche des Kontakts ist derart ausgebildet, dass sie auf dem Keramiksubstrat 2 gleichzeitig einerseits die elektrische Kontaktfläche, beispielsweise die Leiterbahn oder das Lötpad, und andererseits die unbedeckte Keramikoberfläche überdeckt. Beim Lötprozess wird dann durch das Aktivlot gleichzeitig sowohl die elektrische Verbindung zwischen der Kontaktfläche und dem metallischen Kontakt als auch die mechanische Verbindung mit der Keramikoberfläche und dem Kontakt hergestellt.

Bei der Herstellung wird das Keramiksubstrat 2 mit dem Aktivlot 8 bedeckt. Danach wird der Pin 6 mittels einer geeigneten Vorrichtung auf dem Keramiksubstrat 2 fixiert. Beim Erhitzen verbindet sich das Aktivlot 8 mittels chemischer Reaktionen mit dem Metall einerseits und mit der Keramik andererseits, wodurch eine feste Gefügeverbindung zwischen Metall und Keramik hergestellt wird. Da das Aktivlot 8 gleichzeitig elektrisch leitend ist, stellt es eine elektrische Verbindung zwischen dem Pin 6 und den Leiterbahnen auf dem Keramiksubstrat her. An den Pin 6 können dann in üblicher Weise ein Kabel 9, eine Litze oder sonstige elektrische Verbindungen angebracht werden. Dies kann wiederum mittels Löten erfolgen, oder bei besonders hohen Temperaturanforderungen, durch Schweißen oder Crimpen.

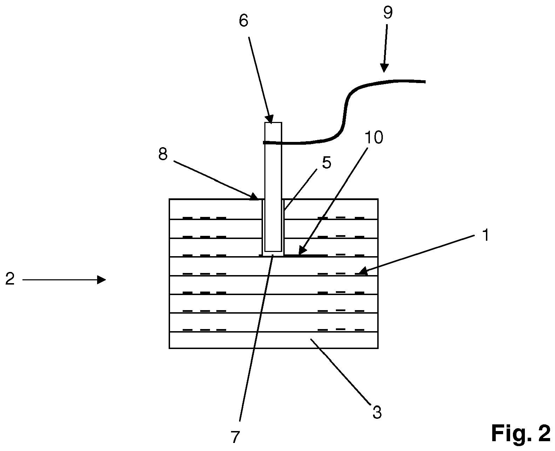

Fig. 2 zeigt eine Ausführungsform eines erfindungsgemäßen Sensors, bei dem das Metall-Anschlusselement in Form eines Metallstifts 6 in eine Ausnehmung 7 des Keramiksubstrates 2 eingebracht ist. Noch im gepressten, aber ungesinterten Zustand (dem sog. grünen Zustand) werden die Keramiklagen entsprechend bearbeitet, also mit Durchbrüchen versehen, woraus dann sogenannte Kavitäten entstehen. Derartige Prozesse kommen auch bei sogenannten Vias (Durchkontaktierungen) bei mehrlagigen Keramiksubstraten zum Einsatz. Um Durchkontaktierungen zwischen den Keramiklagen herzustellen, werden kleine Löcher in das zunächst noch weiche Substrat gestanzt. Diese Löcher werden mit einer leitfähigen Kontakt-Paste 5 gefüllt. Nach dem Übereinanderstapeln und Sintern der Lagen verbindet die leitfähige Paste 5 die Oberseite der Lage mit der Unterseite und stellt damit eine Durchkontaktierung zwischen der auf der oberen Seite einer Lage befindlichen Leiterbahn und der auf der Unterseite befindlichen Leiterbahn her. Diese Durchkontaktierung kann sich auch über mehrere Lagen erstrecken. Es muss beim Übereinanderstapeln lediglich darauf geachtet werden, dass die Lagen exakt übereinander ausgerichtet sind. Wenn Durchbrüche über mehrere Lagen bis zur Oberfläche des Sensorsubstrates reichen, entsteht an der Oberfläche eine Vertiefung (Kavität) in Form eines Sacklochs. Übliche Keramiklagen haben nach dem Sintern eine Dicke von beispielsweise ca. 200 µm. Erstreckt sich das Via über drei Lagen, entsteht ein Sackloch mit einer Tiefe von ca. 600µm.

In dieses Sackloch kann der Metallstift 6 gesteckt und mittels Aktivlöten 8 mit dem Keramiksubstrat 2 verbunden werden. Durch das Verlöten des Metallstifts 6 innerhalb des Keramiksubstrats 2 und der leitfähigen Schicht im Via entsteht eine leitfähige Verbindung, die gleichzeitig mechanisch besonders stabil ist. Die mechanische Stabilität wird also nicht nur durch die Grenzfläche des Aktivlotes 8 hergestellt, sondern zusätzlich durch das Eintauchen des Stiftes 6 in das Keramiksubstrat 2. Dadurch wird die Berührungsfläche zwischen dem Stift 6 und der Keramik vergrößert, ohne dass auf der Oberfläche der Keramik großflächige Auflageflächen erforderlich sind. Dies ist besonders dann vorteilhaft, wenn das Keramiksubstrat 2 selbst eine geringe Fläche besitzt. Außerdem wird durch das Eintauchen die mechanische Stabilität gegen seitliche Belastungen erhöht. Dadurch kann der Stift 6 zum Beispiel beim Ziehen in seitliche Richtung am darauf angeschweißten Kabel nicht abbrechen.

Besonders günstig für die Verwendung der Metall-Anschlussstücke, beispielsweise in Form eines Metallstifts 6 ist Titan, Kovar oder Zirkonium. Die Keramiksubstrate 2 haben nach dem Sintern einen thermischen Ausdehnungskoeffizienten von 5-7 ppm/K. Der Ausdehnungskoeffizient von Titan beträgt 9 ppm/K, von Kovar 5,3 ppm/ und von Zirkonium 5,9 ppm/K. Die Verwendung von Metallen mit ähnlichen oder sogar gleichen Ausdehnungskoeffizienten wie die Keramik ist deshalb von Vorteil, damit bei hohen Temperaturen keine oder nur geringfügige Spannungen an der Aktivlotstelle entstehen. Hohe Temperaturen entstehen zunächst beim Lötprozess selbst, der beispielsweise bei 850°C stattfindet. Wenn nach dem Löten sich das Material abkühlt, können aufgrund stark unterschiedlicher Ausdehnungskoeffizienten an der Verbindungsstelle zwischen dem Metall-Anschlussstück und der Keramik starke innere mechanische Spannungen entstehen, die im schlimmsten Fall dazu führen, das die Lötstelle abreißt. Weiterhin können hohe Temperaturen bei den Umgebungsbedingungen der Sensoren auftreten, da derartige Sensoren gerade für solche Hochtemperaturanwendungen besonders geeignet sind. Die Verwendung von aufeinander abgestimmten Materialien mit ähnlichen Ausdehnungskoeffizienten ist daher für die Stabilität der Metall-Keramik-Verbindung besonders wichtig.

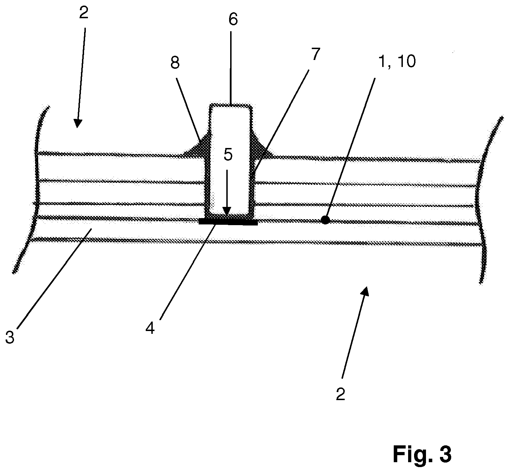

Fig. 3 zeigt in einer schematischen Seitenansicht, geschnitten, das das Sensorelement 1 umfassende mehrschichtige Keramiksubstrat 2, wobei der Sensor bzw. das Sensorelement 1 aus mehrschichtiger Keramik geschaffen ist. Ein hier nicht gezeigtes Gehäuse kann aus Metall bestehen oder zumindest einen metallischen Rand, Rahmen oder dgl. umfassen.

In Fig. 3 ist angedeutet, dass die dort unterste Schicht 3, die die Messelektrode 4 bzw. Messspule umfasst, mit einer Kontakt-Paste 5 überdeckt ist, die vor der Sinterung in das Keramiksubstrat 2 eingebracht ist. Der metallische Kontakt, in Form eines Metallstifts 6, ist in eine Bohrung/Ausnehmung 7 im Keramiksubstrat 2 eingesteckt, wobei eine einwandfreie elektrische Kontaktierung durch Wirkung der Kontakt-Paste 5 gegenüber der Messelektrode 4 bzw. Messspule erfolgt.

Fig. 3 lässt erkennen, dass der Metallstift 6 in das mehrschichtige Keramiksubstrat 2 unmittelbar, d.h. durch Aktivlöten, eingelötet ist, so dass durch das Aktivlöten sowohl eine elektrische Kontaktierung unter Mitwirkung der Kontaktpaste 5 als auch eine mechanische Verbindung gegenüber dem Keramiksubstrat 2 realisiert ist. Das Aktivlot 8 bewirkt die elektrische wie auch feste mechanische Verbindung.

Besondere Vorteile der erfindungsgemäßen Sensoren ergeben sich wie folgt:
- gleichzeitig elektrisch leitfähige und mechanisch stabile Verbindung
- Aktivlöten geeignet für hohe Temperaturen
- Sensorelemente im Keramiksubstrat gekapselt
- kompakte Bauform durch wenig Flächenbedarf der Kontaktierung
- keine mechanischen Spannungen aufgrund Materialwahl
- Sensorelement robust gegen Umwelteinflüsse (Temperatur, Schmutz, Wasser, chemische Einflüsse, etc.).
- Herstellung einer Metall-Keramik-Verbindung ohne Verwendung der Elemente Blei und Zinn, die z.B. in bestimmten Anwendungsbereichen aufgrund der Toxizität nicht eingesetzt werden dürfen.

Hinsichtlich weiterer vorteilhafter Ausgestaltungen der erfindungsgemäßen Vorrichtung und des erfindungsgemäßen Verfahrens wird zur Vermeidung von Wiederholungen auf den allgemeinen Teil der Beschreibung sowie auf die beigefügten Patentansprüche verwiesen.

Schließlich sei ausdrücklich darauf hingewiesen, dass die voranstehend beschriebenen Ausführungsbeispiele der erfindungsgemäßen Vorrichtung und des erfindungsgemäßen Verfahrens lediglich zur Erörterung der beanspruchten Lehre dient, diese jedoch nicht auf die Ausführungsbeispiele einschränken.

### Bezugszeichenliste

- 1: Sensorelement
- 2: Keramiksubstrat
- 3: unterste Schicht
- 4: Messelektrode, Elektrodenfläche
- 5: Kontakt-Paste
- 6: Kontakt, Pin, Metallstift
- 7: Bohrung/Ausnehmung
- 8: Aktivlot
- 9: Kabel, Litze
- 10: Leiterbahn innerhalb von 2

## Patentansprüche

1. Sensor mit einem mehrschichtigen Keramiksubstrat (2), einem metallischen Kontakt (6) und mindestens einem in dem Keramiksubstrat (2) angeordneten Sensorelement (1), welches über den metallischen Kontakt (6) kontaktiert ist, wobei die einzelnen Schichten des Keramiksubstrates (2) durch Sintern fest miteinander verbunden sind, wobei der metallische Kontakt (6) über eine Lötverbindung hergestellt ist, die den Kontakt (6) elektrisch mit dem Sensorelement (1) verbindet und dabei eine feste mechanische Verbindung des Kontakts (6) gegenüber dem Keramiksubstrat (2) erzeugt, wobei der metallische Kontakt (6) in Form eines in das Keramiksubstrat eingesteckten Pins oder Stifts ausgeführt ist, wobei das Sensorelement (1) zur induktiven oder kapazitiven Weg-/Abstands-/Positionmessung dient, wobei die Kontaktierung gegenüber einer oder mehreren Spulen und/oder gegenüber einer oder mehreren Elektrodenflächen (4) ausgebildet ist und wobei der metallische Kontakt (6) in einem Sackloch des Keramiksubstrats (2) eingesteckt ist.

2. Sensor nach Anspruch 1, **dadurch gekennzeichnet, dass** der metallische Kontakt (6) durch Aktivlöten unmittelbar in dem Keramiksubstrat (2) mit diesem verbunden ist.

3. Sensor nach Anspruch 1 oder 2, **dadurch gekennzeichnet, dass** der metallische Kontakt (6) derart dimensioniert ist, dass er mit geringem Spiel in das Keramiksubstrat (2) bishin zu dem zu kontaktierenden Sensorelement (1) einbringbar ist, wobei Aktivlot (8) einen etwaigen Freiraum zwischen dem Keramiksubstrat (2) und dem Kontakt (6) ausreichend und dabei möglichst gleichmäßig ausfüllt.

4. Sensor nach einem der Ansprüche 1 bis 3, **dadurch gekennzeichnet, dass** das durch den metallischen Kontakt (6) zu kontaktierende Sensorelement (1) im Innern angeordnet ist, wobei zwischen dem Sensorelement (1) und dem metallischen Kontakt (6) ein die elektrische Kontaktierung begünstigendes Material, vorzugsweise eine Kontakt-Paste (5), angeordnet ist.

5. Sensor nach einem der Ansprüche 1 bis 4, **dadurch gekennzeichnet, dass** das die elektrische Kontaktierung begünstigende Material, vorzugsweise die Kontakt-Paste (5), vor der eigentlichen Sinterung auf die zu kontaktierende Fläche des Sensorelements (1) aufgebracht bzw. in das Keramiksubstrat (2) einbringbar ist.

6. Verfahren zur Herstellung eines Sensors nach einem der Ansprüche 1 bis 5, wobei mindestens ein Sensorelement (1), welches zur induktiven oder kapazitiven Weg-/Abstands-/Positionsmessung dient, in einem Keramiksubstrat (2) erzeugt wird, wobei das Keramiksubstrat (2) ein mehrschichtiges Keramiksubstrat (2) ist, wobei die einzelnen Schichten des Keramiksubstrats (2) durch Sintern fest miteinander verbunden werden, wobei sowohl zur elektrischen Kontaktierung als auch zur mechanischen Verbindung eines metallischen Kontakts (6) dieser durch Aktivlöten in ein Sackloch des Keramiksubstrats (2) eingebracht und mit dem Keramiksubstrat (2) fest verbunden wird.

7. Verfahren nach Anspruch 6, **dadurch gekennzeichnet, dass** die Kontaktierung des Sensorelements (1) dadurch begünstigt wird, dass vor dem Sintern des Keramiksubstrats (2) ein den elektrischen Kontakt begünstigendes Material, vorzugsweise in Form einer Kontakt-Paste (5), in das Innere des Keramiksubstrats (2) eingebracht wird.

## Claims

1. Sensor having a multi-layered ceramic substrate (2), a metal contact (6) and at least one sensor element (1) which is arranged in the ceramic substrate (2) and which is contacted by means of the metal contact (6), wherein the individual layers of the ceramic substrate (2) are securely connected to each other by means of sintering, wherein the metal contact (6) is produced by means of a solder connection, which electrically connects the contact (6) to the sensor element (1) and which in this instance produces a secure mechanical connection of the contact (6) with respect to the ceramic substrate (2), wherein the metal contact (6) is constructed in the form of a pin or stud which is inserted into the ceramic substrate, wherein the sensor element (1) is used for inductive or capacitive path/spacing/position measurement, wherein the contacting is constructed with respect to one or more coils and/or with respect to one or more electrode faces (4), and wherein the metal contact (6) is inserted in a blind hole of the ceramic substrate (2).

2. Sensor according to claim 1, **characterised in that** the metal contact (6) is connected to the ceramic substrate (2) by means of active soldering directly therein.

3. Sensor according to claim 1 or claim 2, **characterised in that** the metal contact (6) is sized in such a manner that it can be introduced with little play into the ceramic substrate (2) as far as the sensor element (1) which is intended to be contacted, wherein active solder (8) fills any free space between the ceramic substrate (2) and the contact (6) sufficiently and in this instance in the most uniform manner possible.

4. Sensor according to any one of claims 1 to 3, **characterised in that** the sensor element (1) which is intended to be contacted by the metal contact (6) is arranged at the inner side, wherein a material which promotes the electrical contacting, preferably a contact paste (5), is arranged between the sensor element (1) and the metal contact (6) .

5. Sensor according to any one of claims 1 to 4, **characterised in that** the material which promotes the electrical contacting, preferably the contact paste (5), is applied before the actual sintering to the face of the sensor element (1) which is intended to be contacted or can be introduced into the ceramic substrate (2).

6. Method for producing a sensor according to any one of claims 1 to 5, wherein at least one sensor element (1) which is used for inductive or capacitive path/spacing/position measurement is produced in a ceramic substrate (2), wherein the ceramic substrate (2) is a multi-layered ceramic substrate (2), wherein the individual layers of the ceramic substrate (2) are securely connected to each other by means of sintering, wherein, both for electrical contacting and for mechanical connection of a metal contact (6), this contact is introduced by means of active soldering into a blind hole of the ceramic substrate (2) and securely connected to the ceramic substrate (2).

7. Method according to claim 6, **characterised in that** the contacting of the sensor element (1) is promoted **in that** prior to sintering of the ceramic substrate (2) a material which promotes the electrical contact, preferably in the form of a contact paste (5), is introduced inside the ceramic substrate (2).

## Revendications

1. Capteur avec un substrat céramique multicouche (2), un contact métallique (6) et au moins un élément de capteur (1) disposé dans le substrat céramique (2), qui est mis en contact par l'intermédiaire du contact métallique (6), les différentes couches du substrat céramique (2) étant reliées fermement entre elles par frittage, le contact métallique (6) étant réalisé à l'aide d'une liaison par brasage, qui relié électriquement le contact (6) avec l'élément de capteur (1) et produit donc une liaison mécanique ferme par rapport au substrat céramique (2), le contact métallique (6) se présentant sous la forme d'une broche ou d'une tige enfichée dans le substrat céramique, l'élément de capteur (1) permettant une mesure de course/distance/position inductive ou capacitive, la mise en contact étant effectuée par rapport à une ou plusieurs bobines et/ou par rapport à une ou plusieurs surfaces d'électrodes (4) et le contact métallique (6) étant enfiché dans un trou borgne du substrat céramique (2).

2. Capteur selon la revendication 1, **caractérisé en ce que** le contact métallique (6) est relié avec le substrat céramique (2) par brasage actif directement dans celui-ci.

3. Capteur selon la revendication 1 ou 2, **caractérisé en ce que** le contact métallique (6) est dimensionné de façon à ce qu'il puisse être inséré avec un faible jeu dans le substrat céramique (2) jusqu'à l'élément de capteur (1) à mettre en contact, un brasage actif (8) remplissant un espace libre éventuel entre le substrat céramique (2) et le contact (6) de manière suffisante et le plus uniformément possible.

4. Capteur selon l'une des revendications 1 à 3, **caractérisé en ce que** l'élément de capteur (1) à mettre en contact à l'aide du contact métallique (6) est disposé à l'intérieur, un matériau favorisant le contact électrique, de préférence une pâte de contact (5) étant disposée entre l'élément de capteur (1) et le contact métallique (6).

5. Capteur selon l'une des revendications 1 à 4, **caractérisé en ce que** le matériau favorisant le contact électrique, de préférence la pâte de contact (5), peut être appliqué sur la surface à mettre en contact de l'élément de capteur (1) ou inséré dans le substrat céramique (2) avant le frittage proprement dit.

6. Procédé de fabrication d'un capteur selon l'une des revendications 1 à 5, au moins un élément de capteur (1), qui permet une mesure de course/distance/position, étant réalisé dans un substrat céramique (2), le substrat céramique (2) étant un substrat céramique multicouche (2), les différentes couches du substrat céramique (2) étant reliées fermement entre elles par frittage, un contact métallique (6) étant inséré dans un trou borgne du substrat céramique (2) et relié fermement avec le substrat céramique (2) par brasage actif aussi bien pour le contact électrique que pour la liaison mécanique de celui-ci.

7. Procédé selon la revendication 6, **caractérisé en ce que** la mise en contact de l'élément de capteur (1) est favorisée par le fait que, avant le frittage du substrat céramique (2), un matériau favorisant le contact électrique, de préférence sous la forme d'une pâte de contact (5), est inséré à l'intérieur du substrat céramique (2).
